# EUROPEAN PATENT SPECIFICATION

(11) **EP 4 244 653 B1**
(45) Date of publication and mention of the grant of the patent: **18.06.2025**
(21) Application number: 21892689.7
(22) Date of filing: 10.11.2021
(51) Int. Cl.: G01S 7/497, G01S 7/4863, G01S 7/484, G01S 7/481, H01S 5/42, G02B 5/04, G02B 7/02, G01S 7/486, G01S 7/4912

(54) **LIDAR SYSTEM WITH TRANSMIT OPTICAL POWER MONITOR**
LIDAR-SYSTEM MIT VORRICHTUNG ZUR ÜBERWACHUNG DER OPTISCHEN SENDELEISTUNG
SYSTÈME LIDAR À CONTRÔLEUR DE PUISSANCE OPTIQUE D'ÉMISSION

(30) Priority: 12.11.2020 US 202063112735 P
(43) Date of publication of application: 20.09.2023
(73) Proprietor: Opsys Tech Ltd., 5885832 Holon (IL)
(72) Inventor: FABINY, Larry, Boulder, Colorado 80304-1024 (US); MAAYAN, Niv, 7688500 Gealiya (IL); FRIDMAN, Amit, 5647830 Yehud (IL); HAREL, Raphael, 70300 Beer Yaakov (IL); DONOVAN, Mark J., Mountain View, California 94040 (US)
(74) Representative: Dehns
(86) International application number: PCT/US2021/058687
(87) International publication number: WO 2022/103778

(56) References cited:
- US-A- 4 722 599
- US-A1- 2006 132 752
- US-A1- 2007 131 842
- US-A1- 2009 140 047
- US-A1- 2009 273 770
- US-A1- 2016 172 821
- US-A1- 2018 364 356

## Description

The section headings used herein are for organizational purposes only and should not to be construed as limiting the subject matter described in the present application in any way.

### Introduction

Autonomous, self-driving, and semi-autonomous automobiles use a combination of different sensors and technologies such as radar, image-recognition cameras, and sonar for detection and location of surrounding objects. These sensors enable a host of improvements in driver safety including collision warning, automatic-emergency braking, lane-departure warning, lane-keeping assistance, adaptive cruise control, and piloted driving. Among these sensor technologies, light detection and ranging (LiDAR) systems take a critical role, enabling real-time, high-resolution 3D mapping of the surrounding environment.

Most current LiDAR systems used for autonomous vehicles today utilize a small number of lasers, combined with some method of mechanically scanning the environment. Some state-of-the-art LiDAR systems use two-dimensional Vertical Cavity Surface Emitting Lasers (VCSEL) arrays as the illumination source and various types of solid-state detector arrays in the receiver. It is highly desired that future autonomous cars utilize solid-state semiconductor-based LiDAR systems with high reliability and wide environmental operating ranges. These solid-state LiDAR systems are advantageous because they use solid state technology that has no moving parts. However, currently state-of-the-art LiDAR systems have many practical limitations and new systems and methods are needed to improve performance.

US 4,722,599 A1 discloses a ceilometer operating according to a gating method that integrates output signals from a light receiver. US 2016/0172821 A1 discloses a VCSEL assembly including a VCSEL, an optical element, and an optical detector.

According to a first aspect of the invention, a light detection and ranging transmitter with optical power monitoring is provided according to claim 1. Optional features of the first aspect of the invention are provided in dependent claims 2-10.

According to a second aspect of the invention, a method of light detection and ranging with optical power monitoring is provided according to claim 11. Optional features of the second aspect of the invention are provided in dependent claims 12-15.

### Brief Description of the Drawings

The present teaching, in accordance with preferred and exemplary embodiments, together with further advantages thereof, is more particularly described in the following detailed description, taken in conjunction with the accompanying drawings. The skilled person in the art will understand that the drawings, described below, are for illustration purposes only. The drawings are not necessarily to scale; emphasis instead generally being placed upon illustrating principles of the teaching. The drawings are not intended to limit the scope of the Applicant's teaching in any way.
FIG. 1 illustrates an embodiment of a monitored transmitter comprising a reflective directing element for a LiDAR system of the present teaching.
FIG. 2A illustrates an expanded view with additional detail of a portion of the monitored transmitter for a LiDAR system of FIG. 1.
FIG. 2B illustrates a cross-section view of the optical ray trace shown in FIG. 2A.
FIG. 3A illustrates a portion of an embodiment of a monitored transmitter comprising a monitor having a lightpipe for a LiDAR system of the present teaching.
FIG. 3B illustrates a cross-sectional view of the optical ray trace shown in FIG. 3A.
FIG. 4A shows a portion of an embodiment of monitored transmitter comprising a transmissive directing element for a LiDAR system of the present teaching.
FIG. 4B illustrates a cross-sectional view of the optical ray trace shown in FIG. 4A.
FIG. 5 illustrates a block diagram of a LiDAR system that includes a monitored transmitter according to one embodiment of the present teaching.

### Description of Various Embodiments

The present teaching will now be described in more detail with reference to exemplary embodiments thereof as shown in the accompanying drawings. While the present teaching is described in conjunction with various embodiments and examples, it is not intended that the present teaching be limited to such embodiments. On the contrary, the present teaching encompasses various alternatives, modifications and equivalents, as will be appreciated by those of skill in the art. Those of ordinary skill in the art having access to the teaching herein will recognize additional implementations, modifications, and embodiments, as well as other fields of use, which are within the scope of the present disclosure as described herein.

Reference in the specification to "one embodiment" or "an embodiment" means that a particular feature, structure, or characteristic described in connection with the embodiment is included in at least one embodiment of the teaching. The appearances of the phrase "in one embodiment" in various places in the specification are not necessarily all referring to the same embodiment.

It should be understood that the individual steps of the method of the present teaching can be performed in any order and/or simultaneously as long as the teaching remains operable. Furthermore, it should be understood that the apparatus and method of the present teaching can include any number or all of the described embodiments as long as the teaching remains operable.

The present teaching relates generally to Light Detection and Ranging (LiDAR), which is a remote sensing method that uses laser light to measure distances (ranges) to objects. LiDAR systems generally measure distances to various objects or targets that reflect and/or scatter light. Autonomous vehicles make use of LiDAR systems to generate a highly accurate 3D map of the surrounding environment with fine resolution. The systems and methods described herein are directed towards providing a solid-state, pulsed time-of-flight (TOF) LiDAR system with high levels of reliability, while also maintaining long measurement range as well as low cost.

Some embodiments of LiDAR systems according to the present teaching use a laser transmitter that includes a laser array. In some specific embodiments, the laser array comprises Vertical Cavity Surface Emitting Laser (VCSEL) devices. These may include top-emitting VCSELs, bottom-emitting VCSELs, and various types of high-power VCSELs. The VCSEL arrays may be monolithic. The laser emitters may all share a common substrate, including semiconductor substrates or ceramic substrates.

In various embodiments, individual lasers and/or groups of lasers using one or more transmitter arrays can be individually controlled. Each individual emitter in the transmitter array can be fired independently. The optical beam emitted by each laser emitter corresponds to a 3D projection angle subtending only a portion of the total system field-of-view. One example of such a LiDAR system is described in U.S. Patent Publication No. 2017/0307736 A1. In addition, the number of pulses fired by an individual laser, or group of lasers, can be controlled based on a desired performance objective of the LiDAR system. The duration and timing of this sequence can also be controlled to achieve various performance goals.

Some embodiments of LiDAR systems according to the present teaching use detectors and/or groups of detectors in a detector array that can also be individually controlled. See, for example, U.S. Patent Publication No. US 2020/0386868, entitled "Eye-Safe Long-Range Solid-State LiDAR System". This independent control over the individual lasers and/or groups of lasers in the transmitter array and/or over the detectors and/or groups of detectors in a detector array provide for various desirable operating features including control of the system field-of-view, optical power levels, and scanning pattern.

US 4 722 599 discloses a device for measuring height of clouds, the device including a light transmitter consisting of an array of laser diodes. A transmitter control unit monitors the light output power of the laser diode array by means of a photodetector and regulates the amplitude of current pulses driving the laser diode array so as to keep the light output power constant.

US 2016/0172821 discloses a VCSEL assembly which may include multiple VCSELs arranged in an array, a prism having an indentation, and an optical detector. In an embodiment, a portion of the output light of the VCSEL array is reflected by the indentation towards the optical detector to be used for power monitoring. The optical detector is arranged at the same substrate of the VCSEL and used to detect the optical power of the small portion reflected by indentation.

The optical power level(s) emitted by the LiDAR system transmitter is an important parameter that factors into numerous performance metrics of the LiDAR system. This includes, for example, distance, field-of-view, resolution, speed and frame rate and eye safety, among other performance metrics. As such, systems and methods that monitor transmit power for LiDAR systems are desirable. It is desirable that the monitor systems be compact, low-cost and produce a desired precision and accuracy of the monitored parameter.

One feature of the LiDAR systems of the present teaching is the inclusion of optical performance monitoring directly in the LiDAR transmit module. Optical performance monitoring within a LiDAR module may be important for a variety of reasons. For example, incorporating optical power monitoring inside the illuminator assembly can improve calibration, performance, and reliability monitoring. Lasers degrade with lifetime and so it can be useful to monitor the laser output power within the projector assembly itself. For example, by monitoring the light as is exiting the projector, rather than just relying on the received optical signal after the light has been reflected from an external object, it is possible to monitor generated power more accurately and quickly. Also, it is possible to monitor the temperature proximate to the VCSEL lasers. Such a feature is useful to improve the reliability and performance. The optional monitoring of both the temperature and the power can be used not only for diagnostics, but also for controlling the lasers during operation to improve performance and/or lifetime of the system.

Another feature of the present teaching is that the power monitoring elements are configured to monitor light reflected off of, or directed from, various optical devices within the LiDAR transmitter that are providing other functions. The reflected or directed light detected within the transmitter can be used not just for passive monitoring purposes, but also to provide additional active control of the lasers and detectors in the transmitter.

Some embodiments of the performance monitor for LiDAR system transmitters of the present teaching monitor one or more parameters of the light generated by the LiDAR system transmitter itself. For example, the light generated by the transmitters can be monitored for laser wavelength, optical power, pulse timing, and pulse frequency. The wavelength of the generated light can be detected by using a power monitor including a receiver that is not simply a photodiode, but instead comprises a more complicated set of optics that allows detection of wavelength as well as optical power.

In a LiDAR design where multiple wavelengths are used, particularly if the wavelengths are close in absolute value, it may be desired to monitor their absolute or relative values in order to ensure that the system parameters are as intended. There are various known methods of monitoring either absolute wavelength of light generated by the laser, or the relative offset between light generated by the lasers of different wavelength. For example, an etalon-based device could be used as a wavelength monitor.

Embodiments of the systems and method of the present teaching that use multi-wavelength power monitoring also can improve the system robustness for detecting whether a fault is caused by laser degradation or shifts in optical performance metrics. Multi-wavelength power monitoring can also provide redundancy if one set of wavelengths should fail in the transmitter. A partial or full failure in operation of one set of wavelengths in the transmitter would still allow the ability for partial operation of the system using the other set of wavelengths in the transmitter if the optical monitoring for each wavelength is independent.

Another feature of the method and system of the present teaching is that multielement, multi-wavelength optical power monitoring can be realized. One or more directing elements can be positioned to direct light to one or more monitors so that collective and individual powers from the one or more laser elements at one or more wavelengths can be monitored. For example, in one embodiment, the multiple reflection elements can be partial mirrors. In other embodiments, the multiple reflection elements can be configured to project the beam. In some embodiments, the monitors include photodetectors which are each sensitive to only one particular wavelength band of light. This configuration allows monitoring optical power of one or more wavelengths independently, which improves the system capabilities. Multi-wavelength power monitoring according to the present teaching can be configured to monitor for multiple parameters, such as laser wavelength, including absolute wavelength and/or relative wavelength, optical power, pulse timing, and pulse frequency.

Multi-wavelength power monitoring according to the present teaching also improves the LiDAR system's robustness for detecting whether a fault is caused by laser degradation or shifts in optical performance. Multi-wavelength power monitoring is useful, for example, to provide redundancy if one set of wavelengths generated by the transmitter should fail. A partial or full failure in the transmitter's generation of one set of wavelengths would still allow the ability for partial operation of the LiDAR system using the other set of wavelengths if the system is configured so that the optical monitoring for each wavelength band is independent.

It is known that degradation in the performance of the optical transmitter can be determined by monitoring the optical transmitter's laser output power, and then comparing the measured optical power to an expected reference value. The degradation in the performance of the optical transmitter can be caused by either or both of the laser itself or caused by various aspects of the opto-mechanical assembly. The degradation in the performance of the optical transmitter can then be analyzed. For example, U.S. Patent Application Publication No. US 2016/0025842 A1, entitled "System and Method for Monitoring Optical Subsystem Performance in Cloud LiDAR Systems" describes the benefits of laser output power monitoring for a LiDAR system designed for cloud measurements.

Measurements of the optical signal generated by the LiDAR transmitter can also be used in a passive monitoring system. In addition, the optical signal from the LiDAR transmitter can be used for active control of the laser bias current driving the semiconductor laser. A laser diode operates over a range of operating bias currents. Many types of semiconductor laser diode systems are operated in closed loop fashion where a received photodiode current from a monitor photodiode is used as an input to a bias control feedback loop. By monitoring and maintaining the monitor photodiode current at a constant value, which is a largely linear function of the incident power, the output power of the semiconductor laser can be maintained at a near constant value. This condition enables the system to react to environmental changes, such as temperature and mechanical movements, to achieve improved output power stability. Also, monitoring the optical power, and controlling the laser bias in response to the monitored optical power, can be used to accommodate degradation of the laser efficiency over its lifetime, without loss of optical power at system level.

In various embodiments, the transmitter optical signal can be monitored for numerous parameters, including, for example, laser wavelength, optical power, pulse timing, pulse frequency, and pulse duration among other parameters. The laser wavelength can be detected using a power monitor, which is not simply a photodiode or other optical detector, but instead, it is an optical system that allows detection of wavelength as well as optical power. In a LiDAR system design where multiple wavelengths are used, particularly if the wavelengths are close in absolute value, it may be desired to monitor their absolute or relative values in order to ensure that the system parameters are as intended. Various methods of monitoring either absolute wavelength, or the relative offset between lasers of different wavelength, are known within the art. For example, an etalon-based device could be used as a wavelength monitor.

It is desirable for some LiDAR systems to perform a calibration at the beginning of life (BOL) to provide a reference during the lifetime operation of the system. By calibration, we mean the characterization of the initial laser bias, temperature, and output power of the device, and then the subsequent tuning of laser bias and output power as a function of temperature to meet the required performance specifications with suitable margins at BOL. Often this process is performed as part of the manufacturing process for the LiDAR system. The performance parameters, such as the laser bias and the measured optical power, obtained during the calibration process, will often be stored as a function of temperature in the LiDAR system memory as a reference to be used for various operations. Various monitors of the present teaching can provide measured optical power for some of these calibration processes.

During operation of LiDAR systems, the actual temperature can be monitored and used in conjunction with the reference values stored in memory in some form of a look-up table to determine the optical laser bias set point. Alternatively, in combination with an optical power monitor, the actual values of output power, laser bias, and temperature during operation can be compared to the reference values in a look-up table to identify any significant change or degradation in the system which can indicate a potential reliability issue. In various implementations of practical systems, a LiDAR system detecting such changes could then communicate with the overall monitoring system in an automotive other vehicle to identify a need for potential service or repair.

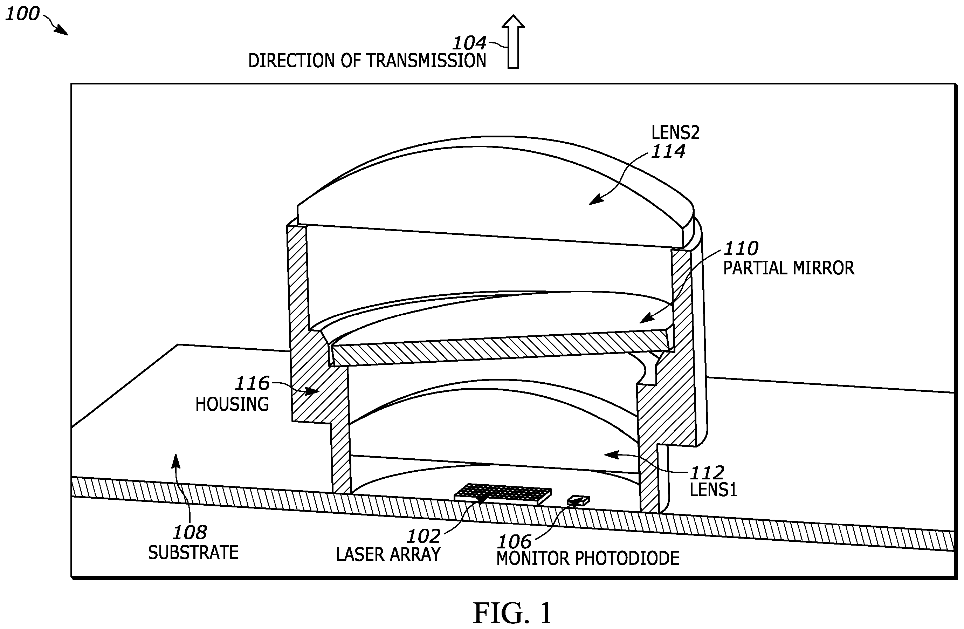

FIG. 1 illustrates an embodiment of a monitored transmitter 100 comprising a reflective directing element 110 for a LiDAR system of the present teaching. The monitored transmitter 100 uses a 2D VCSEL array 102 for the laser source combined with a set of optics for projecting the laser beams along a direction of transmission 104. A monitor photodiode (MPD) 106 is shown mounted on the same substrate 108 as the VCSEL array 102. The monitor photodiode 106 or VCSEL 102 could also be mounted on separate carriers, or in separate packages. In some embodiments, the monitor photodiode 106 and the VCSEL array 102 are nominally positioned in the same plane. In some embodiments, the monitor photodiode 106 and the VCSEL array 102 have the normal projections to their respective surfaces having the same orientation. In some embodiments, this orientation is the same orientation as the direction of transmission 104. A directing element 110, which is located between a first lens 112 and a second lens 114, directs a portion of optical beams generated by the VCSEL array 102 back to the monitor photodiode 106. In some embodiments, the directing element 110 comprises a partial mirror located between a first lens 112 and a second lens 114 that reflects a portion of optical beams generated by the VCSEL array 102 back to the monitor photodiode 106. The first lens 112, second lens 114, and directing element 110 can be mounted in or on a common housing 116 that is secured to substrate 108. The direction of transmission in some embodiments is along the optical axis of the first lens 112 and/or the second lens 114.

The monitored transmitter 100 is described using lenses 112, 114 to project the light in the optical beams generated by the VCSEL array 102. However, one skilled in the art will appreciate that numerous other projecting optical elements can also be used. Numerous known implementations of projecting elements can be used in the monitored transmitter 100 of the present teaching. In various embodiments, these projecting elements serve to shape and project the optical beams toward a target to achieve, for example, a desired field-of-view, target range, resolution, etc. These projecting elements can be configured to produce a common point for the optical beams within the transmitter footprint that allows the directing element to generate an illumination region at the monitor plane such that light from each of the optical beams can be monitored.

It will be understood to those of skill in the art that some embodiments of the present teaching do not require all of the generated optical beams from the VCSEL array 102 to appear in the illumination region. Instead, in some embodiments, only a subset of the optical beams that share the common point for the optical beams are provided in the illumination region and sampled by the monitor. The relative positions of the projecting elements, VCSEL array 102 and directing element serve to determine a desired subset of optical beams that share the common point and therefore are provided in the illumination region.

The directing element 110 of the monitored transmitter 100 embodiment of FIG. 1 is illustrated as being inclined towards the monitor photodiode 106. In other embodiments, the reflective mirror is not inclined towards the photodiode. Instead, the directing element 110 orientation might be such that the normal to the surface of the directing element 110 is parallel to an optical axis of the lens system in order to maintain rotational symmetry. This orientation can be advantageous in some cases for ease of assembly/manufacturing. Also, the directing element 110 is shown in FIG. 1 as a separate optical element, but it should be understood that in some embodiments, one or more of the surfaces of one or more of the two lenses 112, 114 or some other optical elements in the transmitter path, can function to provide the required reflection or direction.

In some embodiments, the optical components including one or more of the first lens 112, second lens 114, and directing element 110, have an optical coating on a surface that is designed to control reflectance. In embodiments, where no monitoring is needed, the optical reflectance is often set as low as possible to maximize the output power from the transmitter 100 in the direction of transmission 104. In some embodiments, an optical coating on the directing element 110 might have a reflectance of up to 5%. In some embodiments, the directing element 110 is not a separate discrete element but instead is an optical coating or set of coatings on one or more of the optical lens surfaces, where the reflectance of the coating has been selected to optimize the measured optical signal.

A feature of the present teaching is that the directing element 110 can be placed within the path of the optical beams being generated by the laser at a common point so that every laser within the transmitter array has some portion of light that can be reflected. See, for example, U.S. Patent No. 10,514,444, which describes a LiDAR transmitter that includes multiple lenses to achieve a small angular divergence of the transmitted optical beam.

In some embodiments, the directing element 110 is a diffractive optic element. In other embodiments, the directing element 110 is both a partially reflective mirror and an optical filter which blocks a portion of the visible spectrum. In one specific embodiments, the directing element is a prism. In some embodiments, the directing element is a holographic element. Numerous known lens configurations can be utilized to achieve the desired lens power, size and relative positions of the first lens 112 and second lens 114 and laser array 102.

In some embodiments, the monitor photodiode 106 is manufactured monolithically with the VCSEL array 102. The monitor photodiode 106 can be fabricated in numerous configurations. For example, in some embodiments, the monitor photodiode 106 is a single photodiode, which receives light from all the individual lasers within the 2D array. In other embodiments, more than one photodiode is used where the outputs of the multiple photodiodes are combined in some fashion to provide a common signal output at some point in the signal chain.

In some embodiments, the monitor photodiode 106 includes an optical element positioned so that an input receives the light propagating from the monitor photodiode 106. For example, the monitor photodiode 106 can include a light guide or a prism positioned to receive light and configured to direct that collected light to a photodiode. The optical element can take all the light in the monitoring aperture, or only a portion of the light from different spatial regions of the monitoring aperture, and then direct that light to one or more photodiodes. For example, the optical element may be a lightpipe as described herein.

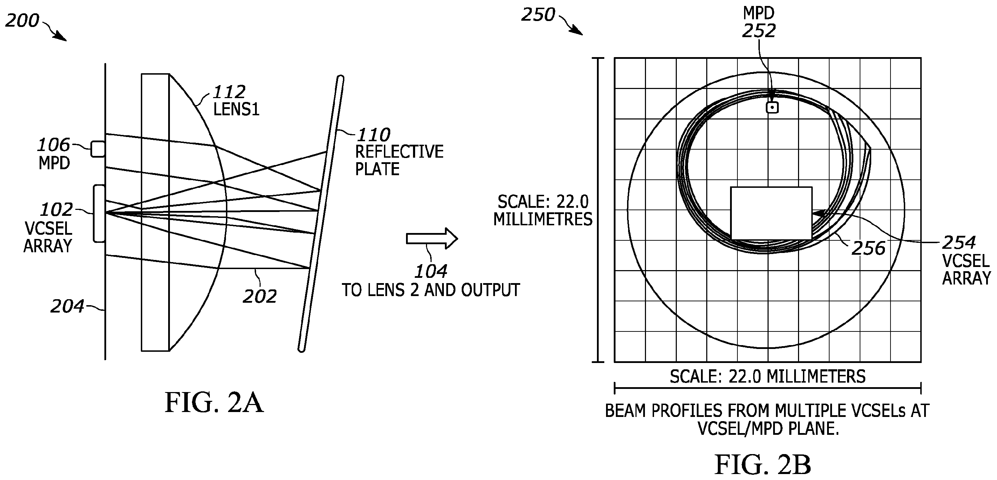

FIG. 2A illustrates an expanded view 200 with additional detail of a portion of the monitored transmitter 100 for a LiDAR system of FIG. 1. FIG. 2A shows an optical ray trace diagram 202 illustrating light emitted from the VCSEL array 102 that passes through lens 1 112, and then reflects off the partially reflective mirror 110 back towards the monitor photodiode 106 and VCSEL array 102. The monitor photodiode 106 is shown as photodiode positioned in the same plane 204 as the VCSEL array 102. The optical beams illustrated in the ray trace diagram 202 are shown as they pass to the directing element 110 where they are redirected to propagate to the second lens (not shown) and then out of the LiDAR transmitter 100 in the direction of transmission 104.

FIG. 2B illustrates a cross-sectional view 250 of the optical ray trace 202 shown in FIG. 2A. Referring to FIGS. 1, 2A and 2B, the cross-sectional view 250 shows the illuminated area 256 encompassing the reflections off of the directing element 110 from different lasers within the VCSEL array 102. The illuminated area 256 of each beam is illustrated mapped over the area 252 of the monitor photodiode 106 and the area 254 of the VCELS array 102. This is because the directing element 110 projects light from a common point of the optical beams generated by the VCSEL, so the illumination region 256 includes at least some light from all the beams. That is, the location of the directing element 110 and the incline angle of the mirror are chosen, so that no matter the location of a particular VCSEL element within the VCSEL array 102, the reflected areas all overlap in the proximity of the monitor photodiode 106. This ensures that the emitted power from every laser within the VCSEL array 102 can be monitored. The monitor photodiode 106 location is often constrained by other electronic components within the LiDAR system.

In some configurations, it is not possible to place the monitor photodiode 106 immediately adjacent to the VCSEL array 102. Instead, for easier manufacturing the monitor photodiode 106 may need to be some distance away from the VCSEL array 102, yet still close enough that it falls within the illuminated area of the reflected optical beams. Thus, the inclination and position of the directing element 110 must be properly chosen such that light from multiple elements in the array 102 overlaps at the monitor photodiode 106.

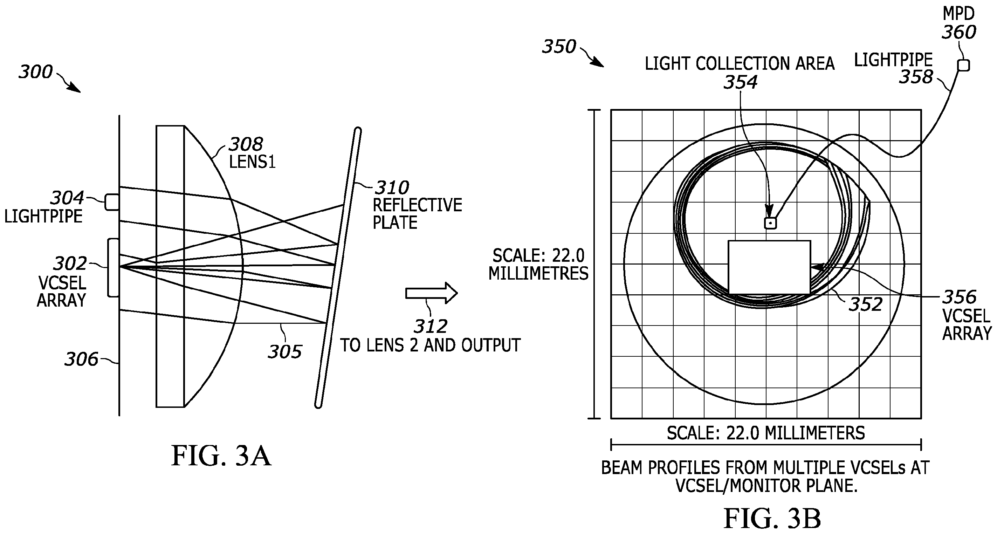

FIG. 3A illustrates a portion 300 of an embodiment of a monitored transmitter comprising a monitor having a lightpipe 304 for a LiDAR system of the present teaching. The embodiments shown in FIG. 2A and FIG. 3A share many features. A VCSEL array 302 and monitor photodiode 304 are positioned in a same plane 306. A first lens 308 directs light beams from the array 302 toward a directing element 310, which may be a partially reflecting mirror, and then to a second lens (not shown) and out the transmitter along a direction of transmission 312. FIG. 3A shows an optical ray trace diagram 305 illustrating light emitted from the VCSEL array 302 that passes through lens 1 308, and then reflects off the partially reflective mirror 310 back towards the lightpipe 304 and the VCSEL array 302.

FIG. 3B illustrates a cross-sectional view 350 of the optical ray trace 202 shown in FIG. 3A. Referring to FIGS. 1, 3A and 3B, the cross-sectional view 350 shows the illuminated area 352 encompassing the reflections off of the directing element 310 from different lasers within the VCSEL array 302. The illuminated area 352 of each beam is illustrated mapped over the area 354 of the monitor area that includes the collection area of a lightpipe 358 and the area 356 of the VCELS array footprint. This lightpipe 358 is shown connected to a remotely located monitor photodiode 360. The illuminated area 352 includes light from each of the optical beams generated by the VCSEL array 302 because the directing element 310 directs light from a common point of the optical beams generated by the VCSEL array 302 to the monitor 304 located at the monitor plane.

In this embodiment, the monitor 304 includes the lightpipe 358. A lightpipe is a device that acts as a waveguide that retains the light internally through total internal reflection as the light propagates along the length of the lightpipe. The lightpipe 358 can be made of glass or plastic, or can be a hollow waveguide with internal mirrored surfaces. Typically, the dimensions of the cross-section of the lightpipe 358 perpendicular to the axis of propagation are much smaller than the propagation distance. The lightpipe 358 can be constructed with fixed or flexible bends to direct the light as desired provided that the bend radius is sufficiently large to maintain total internal reflection. A common example of a lightpipe is a fiber optic cable.

In a lightpipe configuration, instead of the reflected light being measured directly by a photodiode located within the illuminated area as in the embodiment of FIG. 2, the lightpipe 358 is used to capture the light and provide the collected light to a photodiode (not shown). Thus, the lightpipe 358 captures a portion of the light from the illuminated area and redirects it to a monitor photodiode (not shown) that is physically distant from the VCSEL array 302 and also outside the illuminated area.

Embodiments of the monitored transmitter that use a lightpipe do have an additional component, which can increase cost. For example, the lightpipe might incorporate various optical elements including lenses, and mirrors. However, lightpipe embodiments have several potential advantages compared to other embodiments that do not use a lightpipe. One advantage of a lightpipe is that the size of the monitor photodiode for the active area is often restricted in physical size, which limits the optical signal that can be produced. Particularly, if the actual pulse shape, that is often nanoseconds in duration, needs to be measured, the photodiode active area should be small to have good dynamic response. In this case, a lightpipe can be designed with a larger collection area that allows measured light to be condensed/focused onto a smaller photodiode active area, thereby improving the SNR. Because the lightpipe is purely a passive optic component, it can be positioned on top of elements which may be physically close to the VCSEL array 302, such as the electrical drive components. Closer placement of the lightpipe to the VCSEL can also improve the optical efficiency of the monitoring function.

Another potential advantage of using a lightpipe is the ability to locate the monitor photodiode relatively far from the VCSEL array and the VCSEL drive circuits. This feature is important because the drive currents/voltages used to operate the VCSEL can electrically couple and be a source of noise within the optical monitor circuit when the monitor diode is placed physically close to those components. It is highly desirable for the noise level be kept as low as possible in the optical monitor circuit in order to provide high SNR and any false readings.

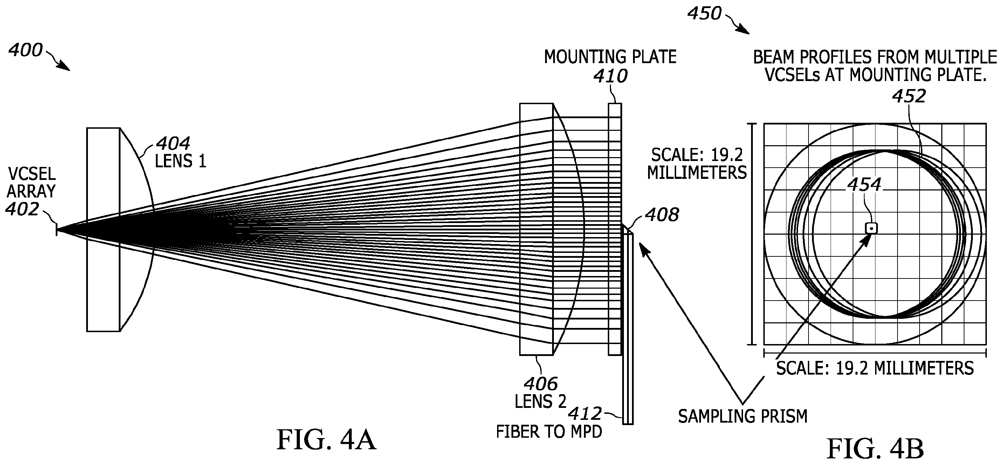

FIG. 4A shows a portion 400 of an embodiment of monitored transmitter comprising a transmissive directing element 410 for a LiDAR system of the present teaching. A VCSEL array 402 generates a plurality of optical beams that are directed to a first and second lens 404, 406. In this embodiment, the light is not reflected back towards the VCSEL array 402. The light impinges on a directing element 410, which in this embodiment is a transmissive element that is a mounting plate. In this configuration, the directing element 410 transmits, or passes, the light at the common point of passage of the optical beams toward the monitor 408. For example, in some embodiments, the monitor 408 is a microprism. The directing element 410 resides at a position with a common point of passage of the optical beams generated by the laser array that defines an illumination region that contains light from each laser. As such, the directing element 410 passes light from each of the optical beams being generated by the laser so that every laser within the VCSEL array 402 has some portion of light provided at an illumination region so that the light can be sampled by the monitor 408 placed within the illumination region. A small portion of the transmitted light in the illumination region is reflected by the monitor 408 in a direction largely perpendicular to the optical axis of the transmitter using a small micro-prism, which can be a diffractive optical element.

The micro-prism of the monitor 408 is shown attached to the directing element 410, which is a mounting plate that in some embodiments is a transparent optical window, and in other embodiments is an optical filter. In some configurations, the directing element 410 is an optical element in the LiDAR transmitter that would be required even without the monitor 408. Thus, the directing element 410 provides two functions, one of which is securing the micro-prism of the monitor 408 and the other is optical in nature. In some configurations, the directing element 410 protects the LiDAR system from the outside environment. The micro-prism in the monitor 410 is shown coupling the light into an optical fiber 412 that has a core that is large enough to maintain the required optical signal level. The optical fiber 412 then directs the light to a monitor photodiode (not shown in the diagram).

FIG. 4B illustrates a cross-sectional view 450 of the optical ray trace shown in FIG. 4A. The cross-sectional view 450 shows the illumination region 452 encompassing the illumination from all of the different lasers within the VCSEL array 402 at the plane of the directing element 410. The illumination region 452 that includes light from each beam is illustrated mapped over the collection area 454 of the sample prism area. The directing element 410 is placed within the path of the optical beams being generated by the laser at a common point so that every laser within the transmitter array has some portion of light that can be sampled by the monitor 408 that includes a microprism.

The embodiment of a monitored transmitter with sampling prism shown in FIG. 4A has some advantages. One feature of this embodiment is that by removing the reflecting plate from within the lens system, the manufacturing and assembly of that lens system is simplified, and rotational symmetry of the lens system is maintained.

The embodiment of a monitored transmitter with optical fiber 412 shown in FIG. 4A also has some advantages. One feature of this embodiment is that the fiber 412 allows the monitor photodiode to be placed physically distant from the VCSEL array 402 and the VCSEL drive circuitry. In some embodiments, the monitor photodiode is not even on the same circuit board as the VCSEL array 402 drive circuitry. This configuration largely eliminates the possibility of the VCSEL array 402 drive circuit resulting in any unwanted noise or spurious signals being present in the optical monitor signal. Eliminating the physical constraints associated with the monitor photodiode being on a common circuit board with the VCSEL array 402 also enables the size and type of optical monitor to be very flexible, which can be advantageous for many reasons including reducing the size and/or complexity of the transmitter or the manufacturing process.

Another feature of the monitored transmitter of the present teaching is that the common point where the light is directed to from the illumination region can be positioned at various points in the optical transmitter. The common point can be determined by the positions of the projecting elements and the laser device. For example, the common point can be positioned before the last optical lens surface in the transmitter optical system. Alternatively, or in addition, the common point can be positioned after the last optical lens surface in the transmitter optical system. In some embodiments, the optical monitor can be attached to an optical window which is the last optical element in the transmitter path and protects the LiDAR system from the outside environment. In other embodiments, the optical monitor can be attached to one of the optical lens surfaces. In yet other embodiments, the optical monitor can be attached to an optical filter element which blocks some portion of the visible spectrum.

It should be understood that the monitored transmitter of the present teaching has been described in connection with particular configurations. These embodiments are only illustrative and not intended to limit the scope of the present teaching. It should be understood that various aspects of the different embodiments can be used in different combinations to achieve the advantages of the method and system of the present teaching.

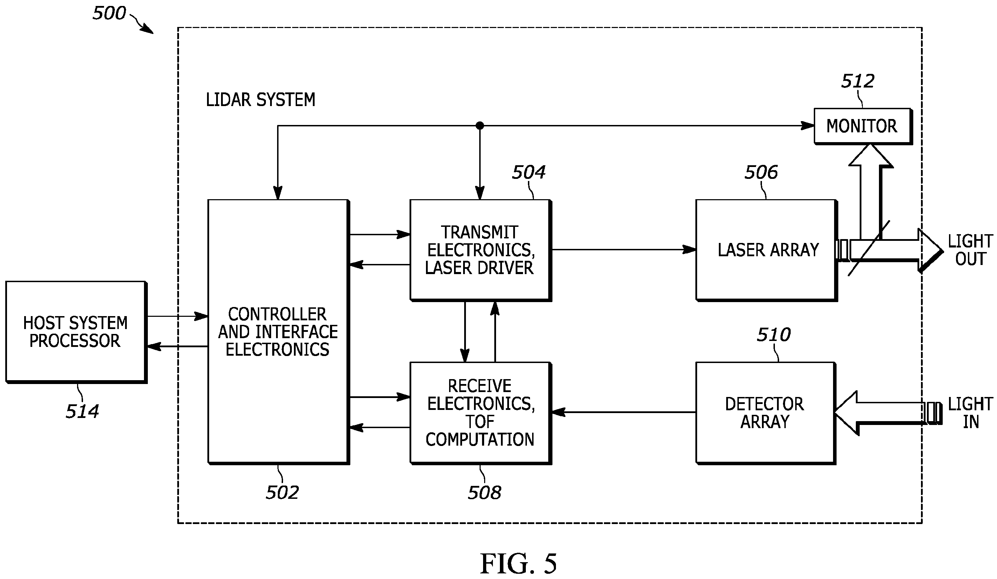

FIG. 5 illustrates a block diagram of an embodiment of a LiDAR system 500 that includes a monitored transmitter according to the present teaching. The LiDAR system 500 has six main components: (1) controller and interface electronics 502; (2) transmit electronics including the laser driver 504; (3) the laser array 506; (4) receive and time-of-flight computation electronics 508; (5) detector array 510; and the (6) monitor 512. The controller and interface electronics 502 controls the overall function of the LiDAR system 500 and provides the digital communication to the host system processor 514. The transmit electronics 504 controls the operation of the laser array 506 and, in some embodiments, sets the pattern and/or power of laser firing of individual elements in the array 506. The receive and time-of-flight computation electronics 508 receives the electrical detection signals from the detector array 510 and then processes these electrical detection signals to compute the range distance through time-of-flight calculations.

The monitor 512 is connected to one or both of the controller and interface electronics 502 and the transmit electronics including laser driver 504. The monitor 512 provides information on the detected signal power, and in combination with processing in one or both of the controller and interface electronics 502 and the transmit electronics including laser driver 504, provides information about laser wavelength, optical power, pulse timing, pulse frequency, and/or pulse duration among other parameters. In some embodiments, the controller and interface electronics 502 directly controls and gets information from the monitor 512. The embodiment of FIG. 5 shows a partial mirror 516 directing light to the monitor 512. However, as is clear to those skilled in the art, the LiDAR system 500 can operate with any of the configuration of the monitor 512 described herein and known variations of these configurations.

In some embodiments, the lasers in the array 506 are operated in closed loop configuration using one or both of the controller and interface electronics 502 and the transmit electronics including laser driver 504 that respond to a received photodiode current from a monitor photodiode that serves as an input to a bias control loop. This configuration can allow the transmitter optical power including the power from some or all of the optical beams generated by the laser array 506 to be maintained at a near constant value. This allows the system to be more stable against temperature and/or mechanical shifts. Also, using a control loop via one or both of the controller and interface electronics 502 and transmit electronics including laser driver 504 that includes monitoring of the optical power and control of the laser bias can accommodate some amount of degradation of the laser efficiency over its lifetime, without loss of optical power at output of the LiDAR system 500.

In some embodiments, the controller and interface electronics 502 calculates an object reflectivity using an optical power reading generated by the monitor 512. The monitored optical power can be used as a reference and then, based on actual photon counting/intensity and pre-calibration, improved reflectivity data can be achieved. This improved reflectivity data can be utilized in systems that are used for various known LiDAR applications that relate to perception.

Another feature of the method and apparatus of the present teaching is that these monitor photodiode implementations can address functional safety of the LiDAR system itself. For example, a control loop via the controller and interface electronics 502 and/or the transmit electronics including laser driver 504, including the power monitor 512 can be used to indicate that the LiDAR transmitter is faulting, for example if the measured optical power is below or above a certain threshold. For example, a control loop using one or both of the controller and interface electronics 502 and transmit electronics including laser driver 504 and including the power monitor 512 can be used to indicate the LiDAR transmitter is operating beyond an eye safety threshold if optical power is above a certain threshold.

The monitored transmitter for a LiDAR system of the present teaching has been described in connection with various embodiments that use a single VCSEL array. It should be understood that the present teaching can be extended to LiDAR transmitters that include more than one VCSEL array. In these embodiments including more than one VCSEL array, the VCSEL arrays are positioned such that the illumination region that covers the monitor has a distinct region for each VCSEL array. In these embodiments, the monitor photodiode can be configured such that it includes more than one photodiode and a separate monitor photodiode can be used for each of the separate illumination regions.

### Equivalents

While the Applicant's teaching is described in conjunction with various embodiments, it is not intended that the Applicant's teaching be limited to such embodiments. On the contrary, the Applicant's teaching encompasses various alternatives, modifications, and equivalents, as will be appreciated by those of skill in the art, which may be made therein without departing from the scope of the claims.

## Claims

1. A light detection and ranging transmitter (100) with optical power monitoring, the transmitter (100) comprising:
a) a laser array (102; 302; 402; 506) positioned in a first plane (204; 306), the laser array (102; 302; 402; 506) being configured to generate a plurality of optical beams that propagate along an optical path in response to an electrical signal provided at an input;
b) a first projecting optical element (112; 308; 404) positioned in the optical path that is configured to project the plurality of optical beams such that the plurality of optical beams at least partially overlaps at a common point;
c) a second projecting optical element (114; 406) positioned in the optical path of the plurality of optical beams after the first projecting optical element (112; 308; 404), and configured to project light from the first projecting optical element (112; 308; 404) in a direction of transmission;
d) a directing optical element (110; 310; 410) positioned at the common point in the optical path of the plurality of beams, the directing optical element (110; 310; 410) being configured to produce an illumination region (256; 352; 452) comprising at least some light from each of the plurality of beams in a second plane (204; 306);
e) a monitor (106; 304; 408; 512) positioned within the illumination region (256; 352; 452) in the second plane (204; 306) that is configured to collect at least some light from each of the plurality of beams, the monitor (106; 304; 408; 512) comprising a photodiode that is configured to generate a detected signal at an output in response to the collected light; and
f) a controller (502) with an input connected to an output of the monitor (106; 304; 408; 512) and an output connected to the input of the laser array (102; 302; 402; 506), the controller (502) being configured to generate the electrical signal in response to the detected signal that controls the laser to achieve a desired operation of the light detection and ranging system transmitter (100).

2. The light detection and ranging transmitter (100) of claim 1 wherein the laser array (102; 302; 402; 506) comprises a VCSEL array, and/or wherein the laser array (102; 302; 402; 506) comprises a two-dimensional array, where at least two lasers within the array can be operated independently.

3. The light detection and ranging transmitter (100) of claim 1 or 2 wherein the first and second plane (204; 306) are co-planar or are positioned at different planes.

4. The light detection and ranging transmitter (100) of any preceding claim wherein the directing optical element (110; 310; 410) and the second projecting optical element (114; 406) are a same optical element.

5. The light detection and ranging transmitter (100) of any preceding claim wherein the directing optical element (110; 310; 410) comprises a partially reflective element, a diffractive element, a prism, a holographic element, and/or a flat optical element.

6. The light detection and ranging transmitter (100) of any preceding claim wherein the directing optical element (110; 310; 410) is both a partially reflective mirror and an optical filter, and/or wherein the directing optical element (110; 310; 410) is a transmissive element.

7. The light detection and ranging transmitter (100) of any preceding claim wherein the directing optical element (110; 310; 410) comprises an optical coating on the second projecting optical element (114; 406).

8. The light detection and ranging transmitter (100) of any preceding claim wherein the achieving the desired operation of the light detection and ranging system transmitter (100) comprises achieving a predetermined performance metric, eye safety, and/or functional safety.

9. The light detection and ranging transmitter (100) of any preceding claim wherein the monitor (106; 304; 408; 512) comprises a photodiode, a sampling prism, and/or a multi-wavelength monitor that is configured to provide wavelength information about the collected light.

10. The light detection and ranging transmitter (100) of any preceding claim wherein the monitor (106; 304; 408; 512) comprises a lightpipe (304; 358) optically coupled to a photodiode (360), optionally wherein the lightpipe (304; 358) is positioned on a same substrate as the laser array (102; 302; 402; 506).

11. A method of light detection and ranging with optical power monitoring, the method comprising:
a) generating a plurality of optical beams at a first plane (204; 306) that propagate along an optical path;
b) projecting the plurality of optical beams such that the plurality of optical beams at least partially overlaps at a common point;
c) directing light from the common point, thereby producing an illumination region (256; 352; 452) comprising at least some light from each of the plurality of beams in a second plane (204; 306);
d) collecting at least some light at the second plane (204; 306) from each of the plurality of beams and generating a detected signal in response to the collected light; and
e) generating an electrical signal in response to the detected signal that controls the generation of the plurality of optical beams to achieve a desired operation of the light detection and ranging system transmitter (100).

12. The method of claim 11 wherein the first and second plane (204; 306) are co-planar or are positioned at different planes.

13. The method of claim 11 or 12 wherein the directing light from the common point comprises diffracting the light, reflecting and filtering the light, and/or transmitting the light.

14. The method of any of claims 11 to 13 wherein the achieving the desired operation of the light detection and ranging system transmitter (100) comprises achieving a predetermined performance metric, eye safe operating conditions, and/or functional safety.

15. The method of any of claims 11 to 14 wherein the generating the electrical signal in response to the detected signal comprises generating multi-wavelength information about the collected light.

## Patentansprüche

1. Lichterfassungs- und Entfernungsmesssender (100) mit optischer Leistungsüberwachung, wobei der Sender (100) Folgendes umfasst:
a) ein Laser-Array (102; 302; 402; 506), das in einer ersten Ebene (204; 306) positioniert ist, wobei das Laser-Array (102; 302; 402; 506) dazu konfiguriert ist, als Reaktion auf ein an einem Eingang bereitgestelltes elektrisches Signal eine Vielzahl optischer Strahlen zu erzeugen, die sich entlang eines optischen Pfads ausbreiten;
b) ein erstes optisches Projektionselement (112; 308; 404), das in dem optischen Pfad positioniert ist und dazu konfiguriert ist, die Vielzahl optischer Strahlen derart zu projizieren, dass die Vielzahl optischer Strahlen einander mindestens teilweise an einem gemeinsamen Punkt überlappen;
c) ein zweites optisches Projektionselement (114; 406), das in dem optischen Pfad der Vielzahl optischer Strahlen nach dem ersten optischen Projektionselement (112; 308; 404) positioniert ist und dazu konfiguriert ist, Licht von dem ersten optischen Projektionselement (112; 308; 404) in eine Übertragungsrichtung zu projizieren;
d) ein optisches Lenkelement (110; 310; 410), das an dem gemeinsamen Punkt in dem optischen Pfad der Vielzahl von Strahlen positioniert ist, wobei das optische Lenkelement (110; 310; 410) dazu konfiguriert ist, einen Beleuchtungsbereich (256; 352; 452) zu erzeugen, der mindestens etwas Licht von jedem der Vielzahl von Strahlen in einer zweiten Ebene (204; 306) umfasst;
e) einen Monitor (106; 304; 408; 512), der innerhalb des Beleuchtungsbereichs (256; 352; 452) in der zweiten Ebene (204; 306) positioniert ist und dazu konfiguriert ist, mindestens etwas Licht von jedem der Vielzahl von Strahlen zu sammeln, wobei der Monitor (106; 304; 408; 512) eine Fotodiode umfasst, die dazu konfiguriert ist, als Reaktion auf das gesammelte Licht ein erfasstes Signal an einem Ausgang zu erzeugen; und
f) eine Steuereinheit (502) mit einem Eingang, der mit einem Ausgang des Monitors (106; 304; 408; 512) verbunden ist, und einem Ausgang, der mit dem Eingang des Laser-Arrays (102; 302; 402; 506) verbunden ist, wobei die Steuereinheit (502) dazu konfiguriert ist, als Reaktion auf das erfasste Signal das elektrische Signal zu erzeugen, das den Laser steuert, um einen gewünschten Betrieb des Lichterfassungs- und Entfernungsmesssystemsenders (100) zu erreichen.

2. Lichterfassungs- und Entfernungsmesssender (100) nach Anspruch 1, wobei das Laser-Array (102; 302; 402; 506) ein VCSEL-Array umfasst und/oder wobei das Laser-Array (102; 302; 402; 506) ein zweidimensionales Array umfasst, wobei mindestens zwei Laser innerhalb des Arrays unabhängig voneinander betrieben werden können.

3. Lichterfassungs- und Entfernungsmesssender (100) nach Anspruch 1 oder 2, wobei die erste und die zweite Ebene (204; 306) koplanar sind oder auf unterschiedlichen Ebenen positioniert sind.

4. Lichterfassungs- und Entfernungsmesssender (100) nach einem vorstehenden Anspruch, wobei das optische Lenkelement (110; 310; 410) und das zweite optische Projektionselement (114; 406) ein und dasselbe optische Element sind.

5. Lichterfassungs- und Entfernungsmesssender (100) nach einem vorstehenden Anspruch, wobei das optische Lenkelement (110; 310; 410) ein teilweise reflektierendes Element, ein diffraktives Element, ein Prisma, ein holographisches Element und/oder ein flaches optisches Element umfasst.

6. Lichterfassungs- und Entfernungsmesssender (100) nach einem vorstehenden Anspruch, wobei das optische Lenkelement (110; 310; 410) sowohl ein teilweise reflektierender Spiegel als auch ein optischer Filter ist, und/oder wobei das optische Lenkelement (110; 310; 410) ein durchlässiges Element ist.

7. Lichterfassungs- und Entfernungsmesssender (100) nach einem vorstehenden Anspruch, wobei das optische Lenkelement (110; 310; 410) eine optische Beschichtung auf dem zweiten optischen Projektionselement (114; 406) umfasst.

8. Lichterfassungs- und Entfernungsmesssender (100) nach einem vorstehenden Anspruch, wobei das Erreichen des gewünschten Betriebs des Lichterfassungs- und Entfernungsmesssystemsenders (100) Erreichen einer vorbestimmten Leistungsmetrik, Augensicherheit und/oder funktionalen Sicherheit umfasst.

9. Lichterfassungs- und Entfernungsmesssender (100) nach einem vorstehenden Anspruch, wobei der Monitor (106; 304; 408; 512) eine Fotodiode, ein Abtastprisma und/oder einen Multiwellenlängenmonitor umfasst, der dazu konfiguriert ist, Wellenlängeninformationen über das gesammelte Licht bereitzustellen.

10. Lichterfassungs- und Entfernungsmesssender (100) nach einem vorstehenden Anspruch, wobei der Monitor (106; 304; 408; 512) einen Lichtleiter (304; 358) umfasst, der optisch mit einer Fotodiode (360) gekoppelt ist, wobei der Lichtleiter (304; 358) optional auf demselben Substrat wie das Laser-Array (102; 302; 402; 506) positioniert ist.

11. Verfahren zur Lichterfassung und Entfernungsmessung mit optischer Leistungsüberwachung, wobei das Verfahren Folgendes umfasst:
a) Erzeugen einer Vielzahl optischer Strahlen auf einer ersten Ebene (204; 306), die sich entlang eines optischen Pfads ausbreiten;
b) Projizieren der Vielzahl optischer Strahlen derart, dass die Vielzahl optischer Strahlen einander mindestens teilweise an einem gemeinsamen Punkt überlappen;
c) Lenken von Licht von dem gemeinsamen Punkt, wodurch ein Beleuchtungsbereich (256; 352; 452) erzeugt wird, der mindestens etwas Licht von jedem der Vielzahl von Strahlen in einer zweiten Ebene (204; 306) umfasst;
d) Sammeln von mindestens etwas Licht auf der zweiten Ebene (204; 306) von jedem der Vielzahl von Strahlen, und Erzeugen eines erfassten Signals als Reaktion auf das gesammelte Licht; und
e) Erzeugen eines elektrischen Signals als Reaktion auf das erfasste Signal, das die Erzeugung der Vielzahl optischer Strahlen steuert, um einen gewünschten Betrieb des Lichterfassungs- und Entfernungsmesssystemsenders (100) zu erreichen.

12. Verfahren nach Anspruch 11, wobei die erste und die zweite Ebene (204; 306) koplanar sind oder auf unterschiedlichen Ebenen positioniert sind.

13. Verfahren nach Anspruch 11 oder 12, wobei das Lenken des Lichts von dem gemeinsamen Punkt, Beugen des Lichts, Reflektieren und Filtern des Lichts und/oder Übertragen des Lichts umfasst.

14. Verfahren nach einem der Ansprüche 11 bis 13, wobei das Erreichen des gewünschten Betriebs des Lichterfassungs- und Entfernungsmesssystemsenders (100) Erreichen einer vorbestimmten Leistungsmetrik, augensicherer Betriebsbedingungen und/oder funktionaler Sicherheit umfasst.

15. Verfahren nach einem der Ansprüche 11 bis 14, wobei das Erzeugen des elektrischen Signals als Reaktion auf das erfasste Signal Erzeugen von Mehrwellenlängeninformationen über das gesammelte Licht umfasst.

## Revendications

1. Émetteur de détection de lumière et de télémétrie (100) avec une surveillance de puissance optique, l'émetteur (100) comprenant :
a) un réseau laser (102 ; 302 ; 402 ; 506) positionné dans un premier plan (204 ; 306), le réseau laser (102 ; 302 ; 402 ; 506) étant configuré pour générer une pluralité de faisceaux optiques qui se propagent le long d'un trajet optique en réponse à un signal électrique fourni au niveau d'une entrée ;
b) un premier élément optique de projection (112 ; 308 ; 404) positionné dans le trajet optique qui est configuré pour projeter la pluralité de faisceaux optiques de telle sorte que la pluralité de faisceaux optiques se chevauchent au moins partiellement en un point commun ;
c) un second élément optique de projection (114 ; 406) positionné dans le trajet optique de la pluralité de faisceaux optiques après le premier élément optique de projection (112 ; 308 ; 404), et configuré pour projeter de la lumière provenant du premier élément optique de projection (112; 308 ; 404) dans une direction de transmission ;
d) un élément optique directeur (110 ; 310 ; 410) positionné au niveau du point commun dans le trajet optique de la pluralité de faisceaux, l'élément optique directeur (110 ; 310 ; 410) étant configuré pour produire une région d'éclairage (256 ; 352 ; 452) comprenant au moins une partie de la lumière provenant de chaque faisceau de la pluralité de faisceaux dans un second plan (204 ; 306) ;
e) un moniteur (106; 304 ; 408 ; 512) positionné dans la région d'éclairage (256 ; 352 ; 452) dans le second plan (204 ; 306) qui est configuré pour collecter au moins une partie de la lumière provenant de chaque faisceau de la pluralité de faisceaux, le moniteur (106 ; 304 ; 408 ; 512) comprenant une photodiode qui est configurée pour générer un signal détecté au niveau d'une sortie en réponse à la lumière collectée ; et
f) un dispositif de commande (502) avec une entrée raccordée à une sortie du moniteur (106 ; 304 ; 408 ; 512) et une sortie raccordée à l'entrée du réseau laser (102 ; 302 ; 402 ; 506), le dispositif de commande (502) étant configuré pour générer le signal électrique en réponse au signal détecté qui commande le laser pour obtenir un fonctionnement souhaité de l'émetteur du système de détection de lumière et de télémétrie (100).

2. Émetteur de détection de lumière et de télémétrie (100) selon la revendication 1, dans lequel le réseau laser (102 ; 302 ; 402 ; 506) comprend un réseau VCSEL et/ou dans lequel le réseau laser (102 ; 302 ; 402; 506) comprend un réseau bidimensionnel, dans lequel au moins deux lasers au sein du réseau peuvent être actionnés indépendamment.

3. Émetteur de détection de lumière et de télémétrie (100) selon la revendication 1 ou 2, dans lequel les premier et second plans (204; 306) sont coplanaires ou sont positionnés au niveau de plans différents.

4. Émetteur de détection de lumière et de télémétrie (100) selon une quelconque revendication précédente, dans lequel l'élément optique directeur (110 ; 310 ; 410) et le second élément optique de projection (114 ; 406) sont un même élément optique.

5. Émetteur de détection de lumière et de télémétrie (100) selon une quelconque revendication précédente, dans lequel l'élément optique directeur (110 ; 310 ; 410) comprend un élément partiellement réfléchissant, un élément diffractif, un prisme, un élément holographique et/ou un élément optique plat.

6. Émetteur de détection de lumière et de télémétrie (100) selon une quelconque revendication précédente, dans lequel l'élément optique directeur (110 ; 310 ; 410) est à la fois un miroir partiellement réfléchissant et un filtre optique et/ou dans lequel l'élément optique directeur (110 ; 310 ; 410) est un élément transmissif.

7. Émetteur de détection de lumière et de télémétrie (100) selon une quelconque revendication précédente, dans lequel l'élément optique directeur (110 ; 310 ; 410) comprend un revêtement optique sur le second élément optique de projection (114 ; 406).

8. Émetteur de détection de lumière et de télémétrie (100) selon une quelconque revendication précédente, dans lequel l'obtention du fonctionnement souhaité de l'émetteur de système de détection de lumière et de télémétrie (100) comprend l'obtention d'une mesure de performance prédéterminée, la sécurité des yeux et/ou la sécurité fonctionnelle.

9. Émetteur de détection de lumière et de télémétrie (100) selon une quelconque revendication précédente, dans lequel le moniteur (106 ; 304 ; 408 ; 512) comprend une photodiode, un prisme d'échantillonnage et/ou un moniteur à plusieurs longueurs d'onde qui est configuré pour fournir des informations de longueur d'onde concernant la lumière collectée.

10. Émetteur de détection de lumière et de télémétrie (100) selon une quelconque revendication précédente, dans lequel le moniteur (106; 304 ; 408 ; 512) comprend un guide de lumière (304 ; 358) couplé optiquement à une photodiode (360), facultativement dans lequel le guide de lumière (304 ; 358) est positionné sur un même substrat que le réseau laser (102 ; 302 ; 402 ; 506).

11. Procédé de détection de lumière et de télémétrie avec une surveillance de puissance optique, le procédé comprenant :
a) la génération d'une pluralité de faisceaux optiques dans un premier plan (204 ; 306) qui se propagent le long d'un trajet optique ;
b) la projection de la pluralité de faisceaux optiques de telle sorte que la pluralité de faisceaux optiques se chevauchent au moins partiellement en un point commun ;
c) le fait de diriger de la lumière à partir du point commun, ce qui permet de produire une région d'éclairage (256 ; 352 ; 452) comprenant au moins une partie de la lumière provenant de chaque faisceau de la pluralité de faisceaux dans un second plan (204 ; 306) ;
d) la collecte d'au moins une partie de la lumière au niveau du second plan (204 ; 306) provenant de chaque faisceau de la pluralité de faisceaux, et la génération d'un signal détecté en réponse à la lumière collectée ; et
e) la génération d'un signal électrique en réponse au signal détecté qui commande la génération de la pluralité de faisceaux optiques pour obtenir un fonctionnement souhaité de l'émetteur de système de détection de lumière et de télémétrie (100).

12. Procédé selon la revendication 11, dans lequel les premier et second plans (204 ; 306) sont coplanaires ou sont positionnés au niveau de plans différents.

13. Procédé selon la revendication 11 ou 12, dans lequel le fait de diriger de la lumière à partir du point commun comprend la diffraction de la lumière, la réflexion et le filtrage de la lumière et/ou la transmission de la lumière.

14. Procédé selon l'une quelconque des revendications 11 à 13, dans lequel l'obtention du fonctionnement souhaité de l'émetteur de système de détection de lumière et de télémétrie (100) comprend l'obtention d'une mesure de performance prédéterminée, des conditions de fonctionnement sans danger pour les yeux et/ou la sécurité fonctionnelle.

15. Procédé selon l'une quelconque des revendications 11 à 14, dans lequel la génération du signal électrique en réponse au signal détecté comprend la génération d'informations à plusieurs longueurs d'onde concernant la lumière collectée.
